# EUROPEAN PATENT SPECIFICATION

(11) **EP 3 073 811 B1**
(45) Date of publication and mention of the grant of the patent: **29.11.2017**
(21) Application number: 15160468.3
(22) Date of filing: 24.03.2015
(51) Int. Cl.: H05K 7/14

(54) **SLIDE RAIL ASSEMBLY**
SCHIENENANORDNUNG
ENSEMBLE DE RAIL DE GLISSEMENT

(43) Date of publication of application: 28.09.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2011 100 935
- US-A1- 2014 217 049

## Description

### Field of the Invention

The present invention relates to a slide rail assembly and more particularly to a slide rail assembly in which a rail and a bracket base can be displaced relative to a bracket in order to increase the distance by which the rail can be displaced.

### Background of the Invention

US Patent No. 7,281,694 B2 discloses a conventional slide rail assembly applicable to the chassis of a server and to a rack whose left and right sides are each provided with a pair of posts. Take one of the two pairs of posts for example. The pair of posts are spaced apart by a predetermined distance depending on the depth of the rack. The slide rail assembly is mounted between the pair of posts and includes a first rail, a second rail, a third rail, a front bracket, and a rear bracket. The first rail has a front end and a rear end. The second rail is movably connected to the first rail. The third rail is movably connected to the second rail. The front bracket is fixedly connected to the front end of the first rail, and the rear bracket is fixedly connected to the rear end of the first rail. The slide rail assembly is mounted to the pair of posts via the front bracket and the rear bracket respectively.

While the aforesaid slide rail assembly is applicable to the chassis of a conventional server, the current trend of server development is toward high-density servers and has given rise to the emergence of chassis different from the conventional ones, such as T-shaped chassis. It is therefore imperative to design slide rail assemblies which can work with such server chassis and feature an increase in the maximum displacement of rails. Document US2014/0217049 discloses a slide rail assembly for mounting a chassis onto a rack, which comprises the features of the preamble of claim 1.

### Summary of the Invention

The present invention relates to a slide rail assembly in which a rail and a bracket base can be displaced relative to a bracket.

According to one aspect of the present invention, a slide rail assembly includes a first rail, a bracket base, a first bracket, and a second rail. The bracket base is connected to the first rail. The first bracket is movably connected to the bracket base. The second rail is movably connected to the first rail and longitudinally displaceable relative to the first rail, and the second rail is able to drive the first rail to displace the bracket base relative to the first bracket. Preferably, the first rail defines a channel; the second rail is longitudinally displaced in the channel of the first rail between a retracted position and an extended position relative to the first rail; and in the course in which the second rail is displaced relative to the first rail from the retracted position toward the extended position relative to the first rail, the second rail drives the first rail to displace the bracket base from a first position to a second position relative to the first bracket. Preferably, the first rail has a front portion and a rear portion, the bracket base is connected to the first rail at a position adjacent to the front portion of the first rail, and the slide rail assembly further includes a second bracket movably connected to the first rail at a position adjacent to the rear portion of the first rail.

According to another aspect of the present invention, a slide rail assembly adapted to mount a chassis to a rack is provided, wherein the rack includes a first post and a second post. The slide rail assembly includes a first rail, a second rail, a third rail, a bracket base, a first bracket, and a second bracket. The first rail has a front portion and a rear portion and defines a channel. The second rail is movably connected to the first rail and can be longitudinally displaced in the channel of the first rail between a retracted position and an extended position relative to the first rail. The third rail is movably connected to the second rail and is mounted with the chassis. The bracket base is connected to the first rail at a position adjacent to the front portion of the first rail. The first bracket is movably connected to the bracket base and is mounted to the first post. The second bracket is movably connected to the first rail at a position adjacent to the rear portion of the first rail and is mounted to the second post. In the course in which the third rail is pulled out relative to the first rail, the third rail drives the second rail into displacement relative to the first rail from the retracted position toward the extended position, and during the displacement, the second rail drives the first rail to displace the bracket base from a first position to a second position relative to the first bracket. Preferably, the chassis includes a first portion and a second portion, the first portion has a greater width than the second portion, and the third rail is mounted to a lateral side of the second portion of the chassis.

According to yet another aspect of the present invention, a slide rail assembly adapted to mount a chassis to a rack is provided, wherein the rack includes a first post and a second post. The slide rail assembly includes a first rail, a second rail, a third rail, a bracket base, a first bracket, and a second bracket. The first rail has a front portion and a rear portion. The second rail is longitudinally movably connected to the first rail. The third rail is longitudinally movably connected to the second rail and is mounted with the chassis. The bracket base is connected to the first rail at a position adjacent to the front portion of the first rail. The first bracket is movably connected to the bracket base and is mounted to the first post. The second bracket is movably connected to the first rail at a position adjacent to the rear portion of the first rail and is mounted to the second post. When driven by the third rail into displacement in an extending direction, the second rail drives the first rail to displace the bracket base from a first position to a second position relative to the first bracket. Preferably, the chassis includes a first portion and a second portion, the first portion has a greater width than the second portion, and the third rail is mounted to a lateral side of the second portion of the chassis.

In some embodiments according to any of the foregoing aspects, the bracket base further includes a through hole, the first bracket further includes an opening and an engaging member, and the engaging member has an elastic arm and an engaging portion transversely connected to the elastic arm and corresponding to the opening. When the bracket base is at the second position relative to the first bracket, the engaging portion of the engaging member extends through the opening of the first bracket into the through hole of the bracket base due to an elastic force of the elastic arm and thus engages with the bracket base.

In some embodiments according to any of the foregoing aspects, the second rail has a disengaging member. In the course in which the second rail is displaced relative to the first rail from the extended position toward the retracted position, the disengaging member of the second rail pushes the engaging portion of the engaging member in a disengaging direction and the bracket base brings the engaging portion of the engaging member out of engagement with the through hole, in order for the second rail to drive the first rail to displace the bracket base from the second position to the first position relative to the first bracket.

In some embodiments according to any of the foregoing aspects, the bracket base further includes a blocking portion, and the first bracket further includes a pressing portion. When the bracket base is at the first position relative to the first bracket, the blocking portion of the bracket base is able to be blocked by the pressing portion of the first bracket.

In some embodiments according to any of the foregoing aspects, the first bracket includes a sidewall and an end plate substantially perpendicularly connected to the sidewall, the slide rail assembly further includes at least one mounting member and a pin which are connected to the end plate, and the pin incorporates a movable, engagement-based connecting member.

In some embodiments according to any of the foregoing aspects, the bracket base further includes an upper wall, a lower wall, and a sidewall connecting between the upper wall and the lower wall; the upper wall, the lower wall, and the sidewall jointly define a channel; and the first bracket includes a sidewall which can be moved in the channel of the bracket base.

In some embodiments according to any of the foregoing aspects, the bracket base further includes an engaging hole, and the first bracket further includes a projecting portion corresponding to the engaging hole. When the bracket base is at the second position relative to the first bracket, the projecting portion of the first bracket extends into the engaging hole of the bracket base.

One of the advantageous features of applying the present invention is that the slide rail assembly has a rail and a bracket base which are displaceable relative to a bracket.

### Brief Description of the Drawings

FIG. 1 is a perspective view of the slide rail assembly according to an embodiment of the present invention;
FIG. 2 is an exploded view of the slide rail assembly in FIG. 1;
FIG. 3 shows how the slide rail assembly in FIG. 1 is used to mount a chassis to a rack so that the chassis can be pulled out of the rack;
FIG. 4A shows how a chassis is mounted to a rack via the slide rail assembly in FIG. 1, with the bracket base at a first position relative to the first bracket;
FIG. 4B shows how the second rail and the third rail of the slide rail assembly in FIG. 4A are displaced relative to the first rail;
FIG. 4C shows a state in which the second rail and the third rail of the slide rail assembly in FIG. 4B have been further displaced relative to the first rail such that the bracket base is at a second position relative to the first bracket;
FIG. 5A shows the slide rail assembly in FIG. 1 mounted to a first post, with the bracket base at the first position relative to the first bracket;
FIG. 5B shows how the second rail and the third rail of the slide rail assembly in FIG. 5A are pulled in the extending direction;
FIG. 6A shows a state in which the slide rail assembly in FIG. 1 is mounted to the first post, and in which the bracket base is at the second position relative to the first bracket;
FIG. 6B shows a state in which the bracket base in FIG. 6A remains at the second position relative to the first bracket, and in which the engaging portion of the engaging member extends into the through hole of the bracket base to engage with the bracket base;
FIG. 7A shows a state in which the bracket base of the slide rail assembly in FIG. 1 is at the first position relative to the first bracket, and in which the engaging portion of the engaging member extends into the opening of the first bracket;
FIG. 7B shows a state in which the bracket base of the slide rail assembly in FIG. 7A is displaced relative to the first bracket in the extending direction;
FIG. 7C shows a state in which the bracket base of the slide rail assembly in FIG. 7A is at the second position relative to the first bracket, and in which the engaging portion of the engaging member extends into the through hole of the bracket base;
FIG. 8A shows a state in which the second rail of the slide rail assembly in FIG. 1 pushes the engaging portion of the engaging member in a disengaging direction;
FIG. 8B shows a state in which the blocking portion of the bracket base of the slide rail assembly in FIG. 8A disengages the engaging portion of the engaging member from the through hole of the bracket base;
FIG. 8C shows a state in which the bracket base in FIG. 8B is at the first position relative to the first bracket;
FIG. 9A shows how the slide rail assembly according to another embodiment of the present invention is mounted to the first post, with the bracket base at a certain position relative to the first bracket; and
FIG. 9B shows a state in which the bracket base in FIG. 9A is at another position relative to the first bracket, and in which the projecting portion of the first bracket extends into the engaging hole of the bracket base.

### Detailed Description of the Invention

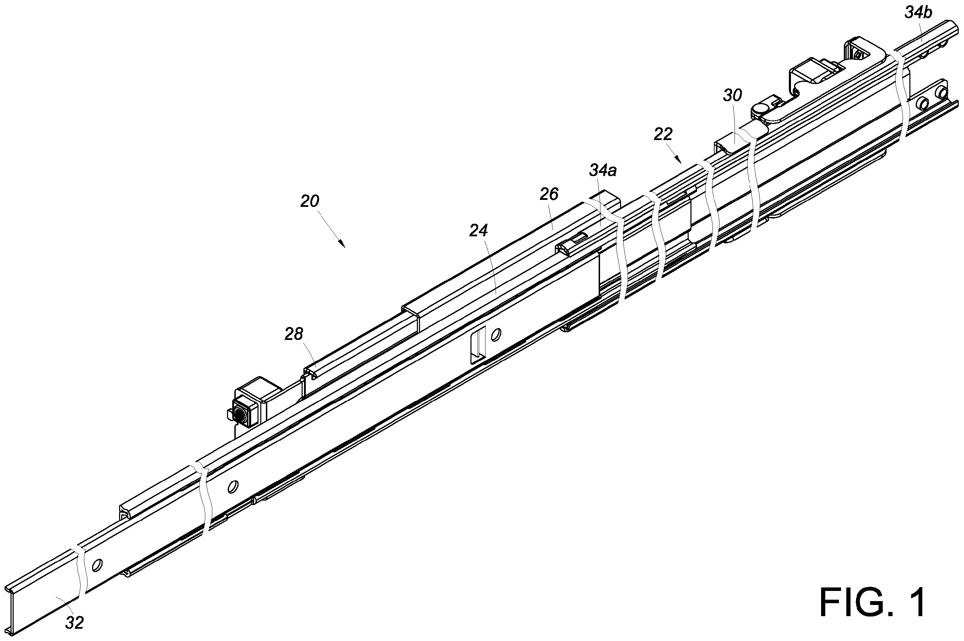

Referring to FIG. 1, a slide rail assembly 20 according to an embodiment of the present invention includes a first rail 22, a second rail 24, a bracket base 26, and a first bracket 28. In this embodiment, the slide rail assembly 20 further includes a second bracket 30 and a third rail 32. The first rail 22, the second rail 24, and the third rail 32 are sequentially connected in a longitudinally movable manner and can be brought to an extended state.

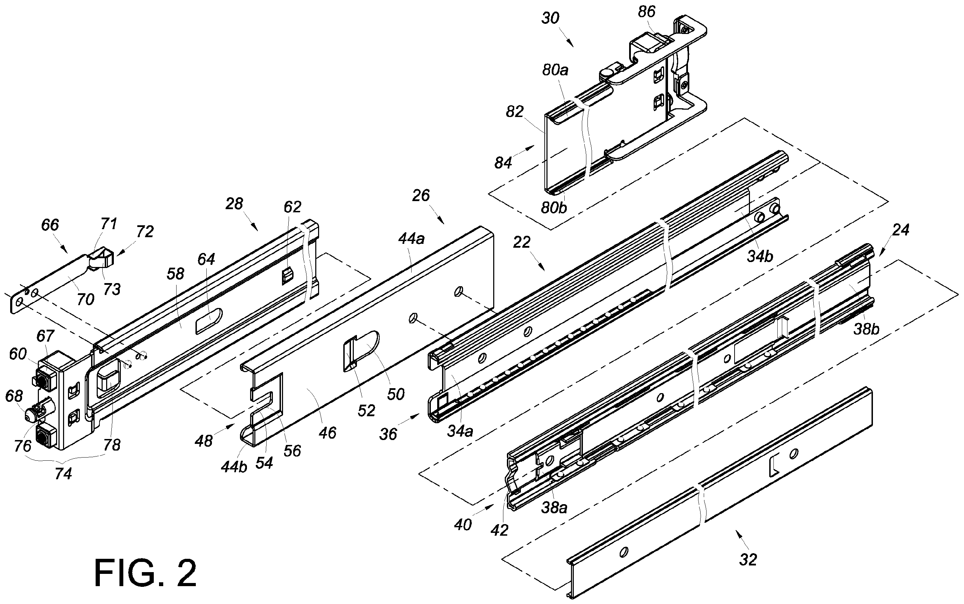

As shown in FIG. 1 and FIG. 2, the first rail 22 has a front portion 34a and a rear portion 34b and defines a channel 36.

The second rail 24 is movably connected to the first rail 22 and is located in the channel 36 of the first rail 22. The second rail 24 has a front portion 38a and a rear portion 38b and defines a channel 40. In this embodiment, the second rail 24 further has a disengaging member 42. The disengaging member 42 can be, but is not necessarily, adjacent to the front portion 38a of the second rail 24.

The bracket base 26 is connected to the first rail 22. For example, the bracket base 26 can be fixedly connected to the first rail 22 at a position adjacent to the front portion 34a by riveting, threaded connection, soldering, or engagement between components, among other connection means. Alternatively, the bracket base 26 can be formed integrally with the first rail 22 and therefore be viewed as a part of the first rail 22. In practice, there are no limitations on the mode of connection between the bracket base 26 and the first rail 22. The bracket base 26 further includes an upper wall 44a, a lower wall 44b, and a sidewall 46 connecting between the upper wall 44a and the lower wall 44b. The upper wall 44a, the lower wall 44b, and the sidewall 46 jointly define a channel 48. Here, the bracket base 26 further includes a through hole 50, a blocking portion 52 adjacent to the through hole 50, a recess 54, and at least one blocking wall 56 adjacent to the recess 54. The through hole 50, the blocking portion 52, the recess 54, and the at least one blocking wall 56 are located at the sidewall 46 of the bracket base 26 but are not necessarily so.

The first bracket 28 is movably connected to the bracket base 26. The first bracket 28 includes a sidewall 58 and an end plate 60 substantially perpendicularly connected to the sidewall 58, wherein the sidewall 58 is movable in the channel 48 of the bracket base 26. In this embodiment, the first bracket 28 also includes a pressing portion 62, an opening 64, an engaging member 66, at least one mounting member 67, and a pin 68. More specifically, the pressing portion 62 and the opening 64 are located at the sidewall 58. The engaging member 66 is elastically connected to the sidewall 58 and can therefore be regarded as a part of the first bracket 28. The engaging member 66 has an elastic arm 70 and an engaging portion 72 transversely connected to the elastic arm 70 and corresponding to the opening 64. The engaging portion 72 includes at least one engaging section 71 and a sloped surface 73 adjacent to the at least one engaging section 71. The at least one mounting member 67 and the pin 68 are connected to the end plate 60. The pin 68 incorporates a movable, engagement-based connecting member 74. The engagement-based connecting member 74 includes an engagement-based connecting portion 76 and a releasing portion 78. The releasing portion 78 can be used to operate (i.e., move) the engagement-based connecting portion 76 so that the engagement-based connecting portion 76 is retractable into the pin 68.

The second bracket 30 is movably connected to the first rail 22 at a position adjacent to the rear portion 34b. The second bracket 30 includes an upper wall 80a, a lower wall 80b, and a sidewall 82 connecting between the upper wall 80a and the lower wall 80b. The upper wall 80a, the lower wall 80b, and the sidewall 82 jointly define a channel 84. The second bracket 30 is movably mounted, via the channel 84, to the first rail 22 at a position adjacent to the rear portion 34b such that the second bracket 30 and the first rail 22 can be longitudinally displaced relative to each other. The second bracket 30 has at least one mounting member 86.

The third rail 32 is movably connected to the second rail 24 and is located in the channel 40 of the second rail 24.

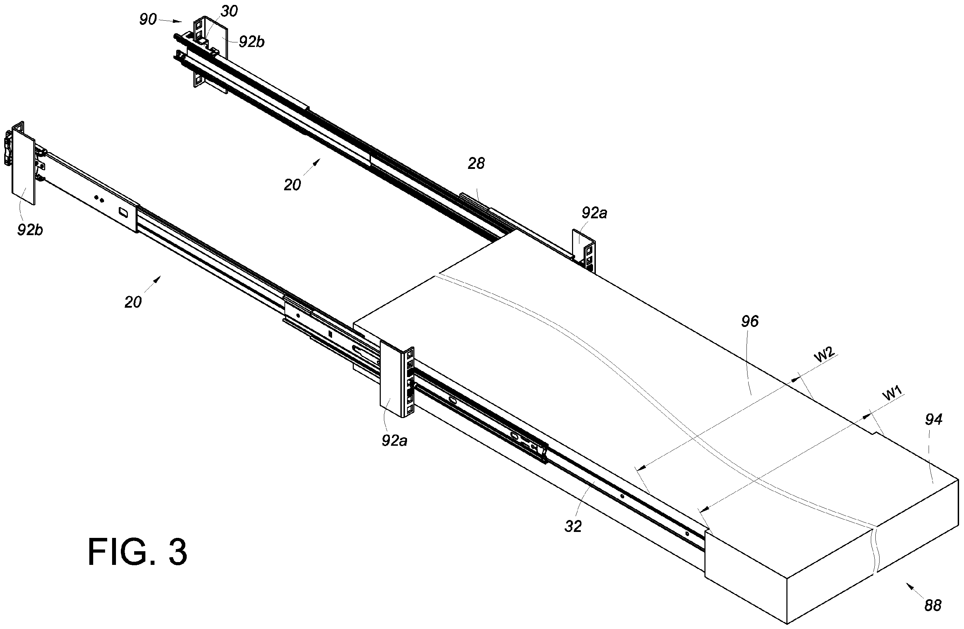

Referring to FIG. 3, a chassis 88 is mounted to a rack 90 by a pair of slide rail assemblies 20. The rack 90 includes two pairs of posts (e.g., two corresponding first posts 92a and two corresponding second posts 92b). Each slide rail assembly 20 has two portions (e.g., the front portion and the rear portion) mounted to one of the first posts 92a and one of the second posts 92b of the rack 90 via the first bracket 28 and the second bracket 30 respectively and is thus mounted to the rack 90. More specifically, the chassis 88 is mounted to the third rails 32 of the slide rail assemblies 20. In this embodiment, the chassis 88 is a generally T-shaped chassis. For example, the chassis 88 includes a first portion 94 and a second portion 96. The first portion 94 has a width W1, and the second portion 96 has a width W2, wherein the width W1 is greater than the width W2.

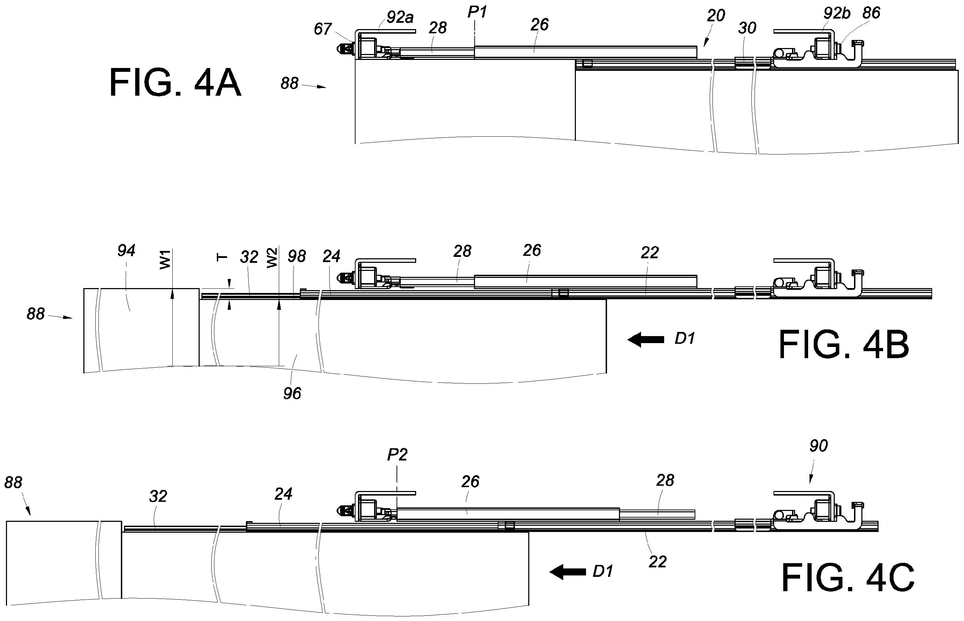

Referring to FIG. 4A, the chassis 88 is mounted to the rack 90 via the slide rail assembly 20, which, as shown in the drawing, is at a retracted position. More specifically, the aforesaid two portions of the slide rail assembly 20 are mounted to the first post 92a and the second post 92b via the mounting member 67 of the first bracket 28 and the mounting member 86 of the second bracket 30 respectively. In FIG. 4A, the bracket base 26 is at a first position P1 relative to the first bracket 28.

Referring to FIG. 4B, the second rail 24 and the third rail 32, when pulled out relative to the first rail 22 (i.e., when pulled in an extending direction D1 from the retracted position toward an extended position), are displaced relative to the first rail 22 and are hence gradually extended. As the width W1 of the first portion 94 of the chassis 88 is greater than the width W2 of the second portion 96 of the chassis 88, the first portion 94 has an additional thickness T as compared with the second portion 96, and because of that, the third rail 32 of the slide rail assembly 20 can only be mounted to a lateral side 98 of the second portion 96 of the chassis 88.

Referring to FIG. 4C, when the second rail 24 and the third rail 32 are further pulled relative to the first rail 22 in the extending direction D1, the third rail 32 drives the second rail 24 further. Once displaced in the extending direction D1 to a predetermined position, the second rail 24 drives the first rail 22 to displace the bracket base 26 from the first position P1 to a second position P2 relative to the first bracket 28. That is to say, by means of the bracket base 26, the first rail 22 can be displaced relative to the first bracket 28 in the extending direction D1. Thus, the distance by which the chassis 88 can be pulled out of the rack 90 is increased, and the first rail 22 is supported by the bracket base 26 while the chassis 88 is being pulled in the extending direction D1. This allows the chassis 88 having a specific shape (e.g., a T shape) and mounted to the rack 90 to be operated as needed.

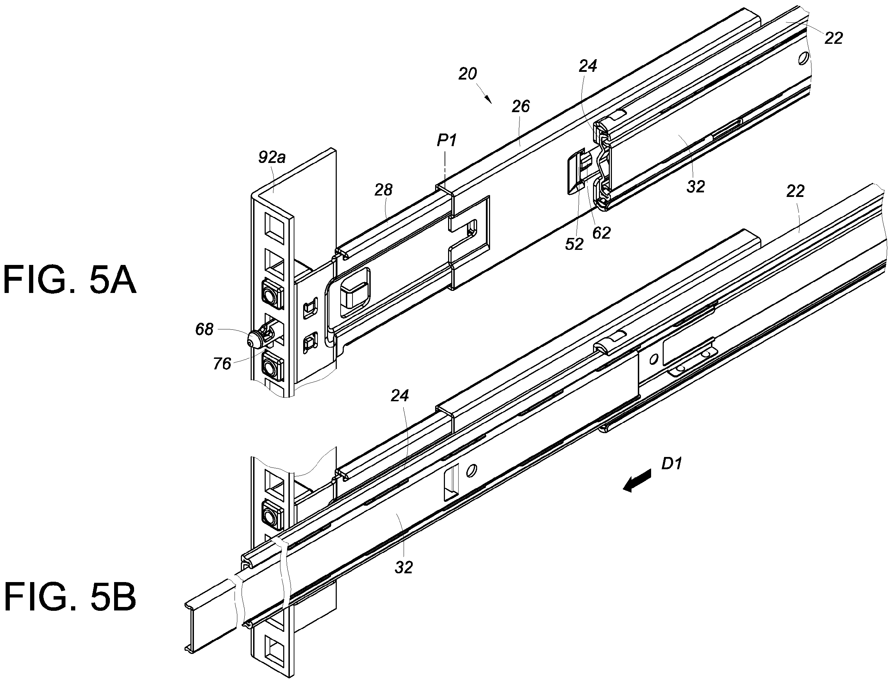

Referring to FIG. 5A, the slide rail assembly 20 is mounted to the first post 92a via the first bracket 28, with the engagement-based connecting portion 76 jutting out of the pin 68 to correspond to and can be blocked by a wall of the first post 92a. In FIG. 5A, the second rail 24 and the third rail 32 are at the retracted position relative to the first rail 22, and the bracket base 26 is at the first position P1 relative to the first bracket 28. When the bracket base 26 is at the first position P1, the blocking portion 52 of the bracket base 26 can be blocked by the pressing portion 62 of the first bracket 28.

In FIG. 5B, the second rail 24 and the third rail 32 are gradually extended as they are pulled in the extending direction D1 from the retracted position relative to the first rail 22.

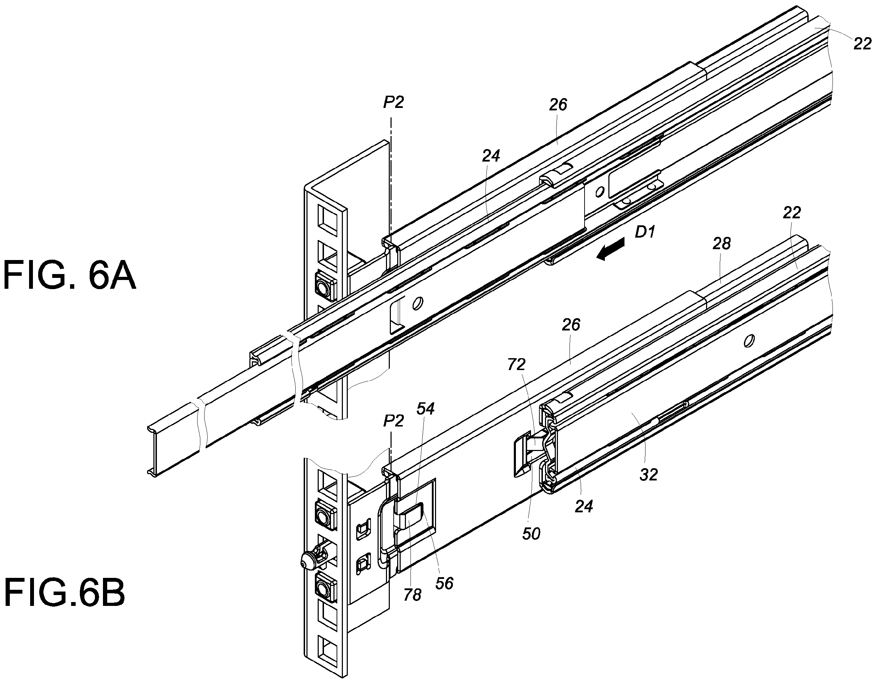

Referring to FIG. 6A, the second rail 24 has been further displaced in the extending direction D1 to the predetermined position and therefore has begun driving the first rail 22. In fact, the bracket base 26 in FIG. 6A has been displaced along with the first rail 22 to the second position P2.

Referring to FIG. 6B, when the bracket base 26 is at the second position P2, the second rail 24 and the third rail 32 can be retracted relative to the first rail 22. More specifically, when the bracket base 26 is at the second position P2, the engaging portion 72 of the engaging member 66 extends from the first bracket 28 into the through hole 50 of the bracket base 26 and engages with the bracket base 26. In addition, when the bracket base 26 is at the second position P2 relative to the first bracket 28, the recess 54 corresponds to the releasing portion 78 such that the releasing portion 78 can be blocked by the at least one blocking wall 56. It is worth mentioning that, when the bracket base 26 is at the second position P2, the second rail 24 and the third rail 32 can be retracted in a retracting direction such that the second rail 24 drives the first rail 22 and consequently the bracket base 26 and thereby brings the bracket base 26 from the second position P2 back to the first position P1 (see FIG. 5A).

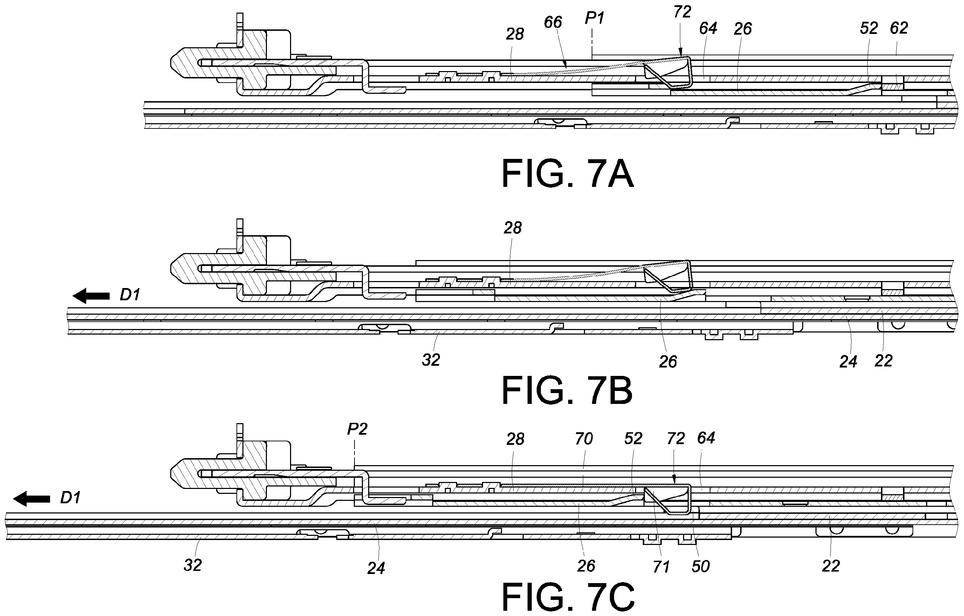

In FIG. 7A, the engaging portion 72 of the engaging member 66 corresponds to and extends into the opening 64 of the first bracket 28. More specifically, when the bracket base 26 is at the first position P1 relative to the first bracket 28, the blocking portion 52 of the bracket base 26 can be pressed against the pressing portion 62 of the first bracket 28.

Referring to FIG. 7B, in the course in which the second rail 24 and the third rail 32 are longitudinally displaced relative to the first rail 22 in the extending direction D1 from the retracted position toward the extended position, the second rail 24 begins driving the first rail 22 upon reaching the predetermined position. As a result, the bracket base 26 is displaced by the first rail 22 in the extending direction D1 from the first position P1 relative to the first bracket 28.

Referring to FIG. 7C, in the course in which the first rail 22 is further driven by the second rail 24 in the extending direction D1, the blocking portion 52 of the bracket base 26 is moved past the engaging portion 72, and the bracket base 26 is displaced to the second position P2 relative to the first bracket 28. More specifically, when the bracket base 26 is at the second position P2, the engaging portion 72 of the engaging member 66 extends through the opening 64 of the first bracket 28 into the through hole 50 of the bracket base 26 due to the elastic force of the elastic arm 70, and the engaging section 71 of the engaging member 66 is pressed against the blocking portion 52 and thus engages with the bracket base 26.

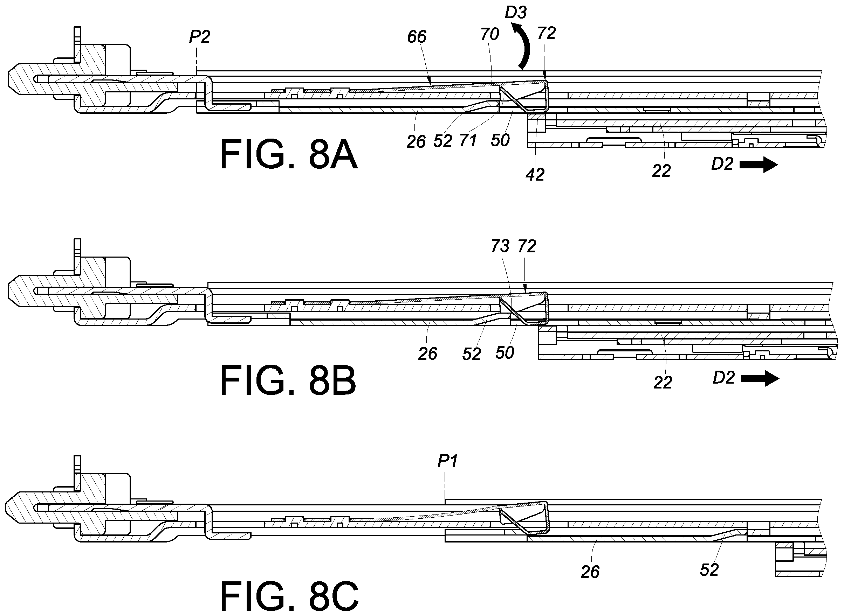

Referring to FIG. 8A to FIG. 8C, in the course in which the second rail 24 is longitudinally displaced relative to the first rail 22 in a retracting direction D2 from the extended position toward the retracted position, the disengaging member 42 of the second rail 24 pushes the engaging portion 72 of the engaging member 66 in a disengaging direction D3 such that the engaging section 71 of the engaging portion 72 is moved away from the blocking portion 52 of the bracket base 26. In addition, the blocking portion 52 of the bracket base 26 is able to push the sloped surface 73 of the engaging portion 72 and thus move the engaging portion 72 of the engaging member 66 in the disengaging direction D3, bringing the engaging portion 72 of the engaging member 66 out of engagement with the through hole 50 of the bracket base 26. Consequently, the second rail 24 displaces the first rail 22 in the retracting direction D2, and the first rail 22, in turn, displaces the bracket base 26 from the second position P2 to the first position P1.

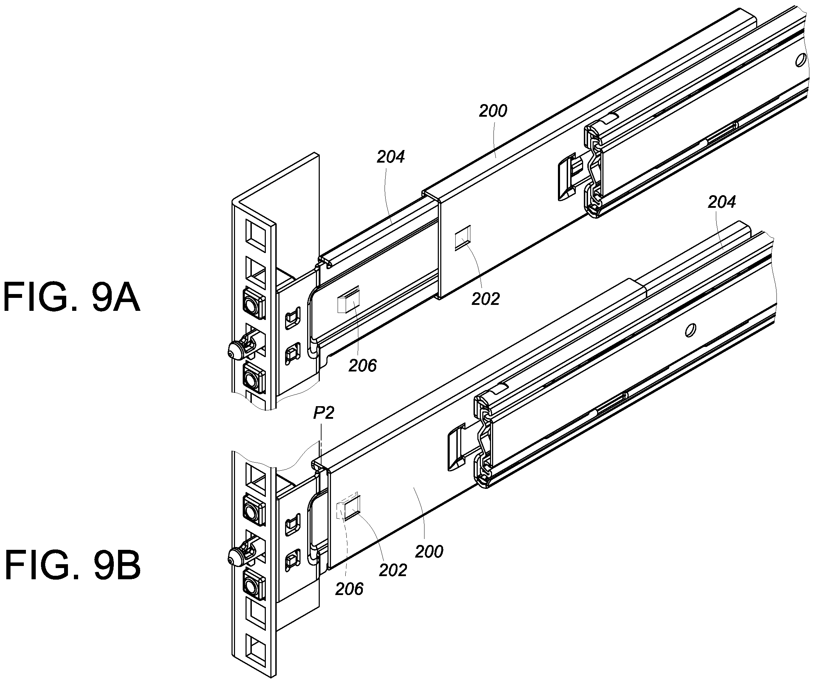

FIG. 9A and FIG. 9B show the slide rail assembly according to another embodiment of the present invention. This embodiment differs from the previous one substantially in that the bracket base 200 includes an engaging hole 202 and that the first bracket 204 includes a projecting portion 206 corresponding to the engaging hole 202. When the bracket base 200 is at the second position P2 relative to the first bracket 204, the projecting portion 206 of the first bracket 204 extends into the engaging hole 202 of the bracket base 200 to engage with the bracket base 200.

While the present invention has been disclosed by way of the preferred embodiments described above, the embodiments are not intended to be restrictive of the present invention. The scope of patent protection sought by the applicant is defined by the appended claims.

## Claims

1. A slide rail assembly (20) for mounting a chassis (88) to a rack (90), comprising:
a first rail (22) defining a channel (36);
a bracket base (26, 200) connected to the first rail (22);
a first bracket (28, 204) adapted to be fixed to a rack and to which the bracket base (26, 200) is movably connected; and
a second rail (24) movably connected to the first rail (22) and longitudinally displaceable relative to the first rail (22), wherein
the first bracket (28, 204) includes an opening (64) and an engaging member (66), the engaging member (66) has an elastic arm (70) and an engaging portion (72) transversely connected to the elastic arm (70) and corresponding to the opening (64),
**characterized in,**
**that** the second rail (24) is able to drive the first rail (22) while being displaced within the channel (36) relative to the first rail (22) from a retracted position to an extended position to displace the bracket base (26, 200) relative to the first bracket (28, 204) from a first position (P1) to a second position (P2), and
**that** the bracket base (26, 200) is fixedly connected to the first rail (22) and includes a through hole (50), and
when the bracket base (26, 200) is at the second position (P2) relative to the first bracket (28, 204), the engaging portion (72) of the engaging member (66) extends through the opening (64) of the first bracket (28, 204) into the through hole (50) of the bracket base (26, 200) due to an elastic force of the elastic arm (70) and engages with the bracket base (26, 200).

2. The slide rail assembly (20) as claimed in claim 1, wherein while being displaced in an extending direction (D1) from the retracted position toward the extended position relative to the first rail (22), the second rail (24) drives the first rail (22) to displace the bracket base (26, 200) from the first position (P1) to the second position (P2) relative to the first bracket (28, 204).

3. The slide rail assembly (20) as claimed in claim 1, wherein the first rail (22) has a front portion (34a) and a rear portion (34b), the bracket base (26, 200) is connected to the first rail (22) at a position adjacent to the front portion (34a) of the first rail (22), and the slide rail assembly (20) further includes another bracket (30) movably connected to the first rail (22) at a position adjacent to the rear portion (34b) of the first rail (22).

4. The slide rail assembly (20) as claimed in claim 1, wherein the second rail (24) further has a disengaging member (42), and while the second rail (24) is being displaced from the extended position toward the retracted position relative to the first rail (22), the disengaging member (42) of the second rail (24) pushes the engaging portion (72) of the engaging member (66) in a disengaging direction (D3) and the bracket base (26, 200) brings the engaging portion (72) of the engaging member (66) out of engagement with the through hole (50), in order for the second rail (24) to drive the first rail (22) to displace the bracket base (26, 200) from the second position (P2) to the first position (P1) relative to the first bracket (28, 204).

5. The slide rail assembly (20) as claimed in claim 2, wherein the bracket base (26, 200) further includes a blocking portion (52), the first bracket (28, 204) further includes a pressing portion (62), and when the bracket base (26, 200) is at the first position (P1) relative to the first bracket (28, 204), the blocking portion (52) of the bracket base (26, 200) is able to be blocked by the pressing portion (62) of the first bracket (28, 204).

6. The slide rail assembly (20) as claimed in claim 1, wherein the first bracket (28, 204) includes a sidewall (58) and an end plate (60) substantially perpendicularly connected to the sidewall (58), the slide rail assembly (20) further includes at least one mounting member (67) and a pin (68) which are connected to the end plate (60), and the pin (68) incorporates a movable, engagement-based connecting member (74).

7. The slide rail assembly (20) as claimed in claim 1, wherein the bracket base (26, 200) further includes an upper wall (44a), a lower wall (44b), and a sidewall (46) connecting between the upper wall (44a) and the lower wall (44b); the upper wall (44a), the lower wall (44b), and the sidewall (46) jointly define a channel (48); and the first bracket (28, 204) includes a sidewall (58) movable in the channel (48) of the bracket base (26, 200).

8. The slide rail assembly (20) as claimed in claim 2, wherein the bracket base (200) further includes an engaging hole (202), the first bracket (204) further includes a projecting portion (206) corresponding to the engaging hole (202), and when the bracket base (200) is at the second position (P2) relative to the first bracket (204), the projecting portion (206) of the first bracket (204) extends into the engaging hole (202) of the bracket base (200).

9. The slide rail assembly (20) as claimed in claim 1, further comprising a third rail (32) and a second bracket (30), wherein the rack (90) includes a first post (92a) and a second post (92b); the first rail (22) has a front portion (34a) and a rear portion (34b); the third rail (32) is movably connected to the second rail (24) and mounted with the chassis (88); the bracket base (26, 200) is connected to the first rail (22) at a position adjacent to the front portion (34a) of the first rail (22); the first bracket (28, 204) is mounted to the first post (92a); the second bracket (30) is movably connected to the first rail (22) at a position adjacent to the rear portion (34b) of the first rail (22) and mounted to the second post (92b); and while being pulled out relative to the first rail (22), the third rail (32) drives the second rail (24) into displacement in an extending direction (D1) from the retracted position toward the extended position relative to the first rail (22), and during the displacement, the second rail (24) drives the first rail (22) to displace the bracket base (26, 200) from the first position (P1) to the second position (P2) relative to the first bracket (28, 204).

10. The slide rail assembly (20) as claimed in claim 1, further comprising a third rail (32) and a second bracket (30), wherein the rack (90) includes a first post (92a) and a second post (92b); the first rail (22) has a front portion (34a) and a rear portion (34b); the third rail (32) is longitudinally movably connected to the second rail (24) and mounted with the chassis (88); the bracket base (26, 200) is connected to the first rail (22) at a position adjacent to the front portion (34a) of the first rail (22); the first bracket (28, 204) is mounted to the first post (92a); the second bracket (30) is movably connected to the first rail (22) at a position adjacent to the rear portion (34b) of the first rail (22) and mounted to the second post (92b); and when driven by the third rail (32) into displacement in an extending direction (D1), the second rail (24) drives the first rail (22) to displace the bracket base (26, 200) from the first position (P1) to the second position (P2) relative to the first bracket (28, 204).

11. The slide rail assembly (20) as claimed in claim 9 or 10, wherein the chassis (88) includes a first portion (94) and a second portion (96), the first portion (94) has a width (W1) greater than a width (W2) of the second portion (96), and the third rail (32) is mounted to a lateral side (98) of the second portion (96) of the chassis (88).

12. The slide rail assembly (20) as claimed in claim 10, wherein the bracket base (26, 200) further includes an upper wall (44a), a lower wall (44b), and a sidewall (46) connecting between the upper wall (44a) and the lower wall (44b); the upper wall (44a), the lower wall (44b), and the sidewall (46) jointly define a channel (48); the first bracket (28, 204) includes a sidewall (58) and an end plate (60) substantially perpendicularly connected to the sidewall (58); and the sidewall (58) of the first bracket (28, 204) is movable in the channel (48) of the bracket base (26, 200).

## Patentansprüche

1. Eine Laufschienenmontage (20) zum Montieren eines Fahrwerks (88) an ein Gestell (90), umfassend:
eine erste Schiene (22), die einen Kanal (36) bildet;
eine Halterungsbasis (26, 200), die an der ersten Schiene (22) befestigt ist;
eine erste Halterung (28, 204), die an das Gestell befestigt werden kann und an das die Halterungsbasis (26, 200) beweglich montiert ist; und
eine zweite Schiene (24), die beweglich an der ersten Schiene (22) befestigt und der Länge nach relativ zur ersten Schiene (22) verschiebbar ist, worin
die erste Halterung (28, 204) eine Öffnung (64) aufweist und mit einem Einrückglied (66) gebildet ist; das Einrückglied (66) mit einem elastischen Arm (70) und mit einem Einrückteil (72) gebildet ist, worin der Einrückteil (72) quer am elastischen Arm (70) und in Übereinstimmung mit der Öffnung (64) befestigt ist;
**dadurch gekennzeichnet, dass**
die zweite Schiene (24) die erste Schiene (22) antreiben kann und dabei im Kanal (36) relativ zur ersten Schiene (22) aus einer eingezogenen Position in eine ausgestreckte Position verschoben werden kann, um die Halterungsbasis (26, 200) relativ zur ersten Halterung (28, 204) aus einer ersten Position (P1) in eine zweite Position (P2) zu verschieben, und
die Halterungsbasis (26, 200) fest an der ersten Schiene (22) befestigt ist und ein Durchgangsloch (50) aufweist, und
wenn die Halterungsbasis (26, 200) in der zweiten Position (P2) relativ zur ersten Halterung (28, 204) ist sich der Einrückteil (72) des Einrückglieds (66) wegen der elastischen Kraft des elastischen Arms (70) durch die Öffnung (64) der ersten Halterung (28, 204) in das Durchgangsloch (50) der Halterungsbasis (26, 200) erstreckt und mit der Halterungsbasis (26, 200) in Eingriff gebracht wird.

2. Die Laufschienenmontage (20) nach Anspruch 1, worin beim Verschieben in eine Ausfahrrichtung (D1) aus der eingezogenen Position in eine ausgestreckte Position relativ zur ersten Schiene (22) diese erste Schiene (22) mit der zweiten Schiene (24) angetrieben wird, um die Halterungsbasis (26, 200) aus der ersten Position (P1) in die zweite Position (P2) relativ zur ersten Halterung (28, 204) anzutreiben.

3. Die Laufschienenmontage (20) nach Anspruch 1, worin die erste Schiene (22) einen vorderen Teil (34a) und einen hinteren Teil (34b) aufweist; die Halterungsbasis (26, 200) an der ersten Schiene (22) in einer Position angrenzend zum vorderen Teil (34a) der ersten Schiene (22) befestigt ist; die Laufschienenmontage (20) mit einer weiteren Halterung (30) gebildet ist, die beweglich an der ersten Schiene (22) in einer Position angrenzend zum hinteren Teil (34b) der ersten Schiene (22) befestigt ist.

4. Die Laufschienenmontage (20) nach Anspruch 1, worin die zweite Schiene (24) weiter mit einem Ausrückglied (42) gebildet ist; beim Verschieben der zweiten Schiene (24) aus der ausgestreckten Position in die eingezogene Position relativ zur ersten Schiene (22) der Einrückteil (72) des Einrückglieds (66) mit dem Ausrückglied (42) der zweiten Schiene (24) in eine Ausrückrichtung (D3) geschoben wird, während der Einrückteil (72) des Einrückglieds (66) mit der Halterungsbasis (26, 200) aus dem Durchgangsloch (50) ausgerückt wird, um mit der zweiten Schiene (24) die erste Schiene (22) anzutreiben, um somit die Halterungsbasis (26, 200) aus der zweiten Position (P2) in die erste Position (P1) relativ zur ersten Halterung (28, 204) zu verschieben.

5. Die Laufschienenmontage (20) nach Anspruch 2, worin die Halterungsbasis (26, 200) weiter mit einem Sperrteil (52) gebildet ist; die erste Halterung (28, 204) weiter mit einem Preßteil (62) gebildet ist; wenn die Halterungsbasis (26, 200) in der ersten Position (P1) relativ zur ersten Halterung (28, 204) ist der Sperrteil (52) der Halterungsbasis (26, 200) mit dem Preßteil (62) der ersten Halterung (28, 204) blockiert werden kann.

6. Die Laufschienenmontage (20) nach Anspruch 1, worin die erste Halterung (28, 204) eine Seitenwand (58) und ein Endplättchen (60) aufweist, wobei letzteres im Wesentlichen senkrecht zur Seitenwand (58) befestigt ist; die Laufschienenmontage (20) weiter mit mindestens einem Montageglied (67) und mit einem Stift (68) gebildet ist, wobei der Stift (68) am Endplättchen (60) befestigt ist; der Stift (68) ein bewegliches Verbindungsglied (74) aufweist, das in Eingriff gebracht werden kann.

7. Die Laufschienenmontage (20) nach Anspruch 1, worin die Halterungsbasis (26, 200) weiter eine obere Wand (44a), eine untere Wand (44b) und eine Seitenwand (46) aufweist, wobei die Seitenwand (46) zwischen der oberen Wand (44a) und der unteren Wand (44b) gebildet ist; die obere Wand (44a), die untere Wand (44b) und die Seitenwand (46) zusammen einen Kanal (48) bilden; die erste Halterung (28, 204) mit einer Seitenwand (58) gebildet ist, die beweglich im Kanal (48) der Halterungsbasis (26, 200) vorgesehen ist.

8. Die Laufschienenmontage (20) nach Anspruch 2, worin die Halterungsbasis (200) weiter ein Einrückloch (202) aufweist; die erste Halterung (204) weiter mit einem vorstehenden Teil (206) in Übereinstimmung mit dem Einrückloch (202) gebildet ist; wenn die Halterungsbasis (200) in der zweiten Position (P2) relativ zur ersten Halterung (204) ist sich der vorstehende Teil (206) der ersten Halterung (204) in das Einrückloch (202) der Halterungsbasis (200) erstreckt.

9. Die Laufschienenmontage (20) nach Anspruch 1, weiter umfassend eine dritte Schiene (32) und eine zweite Halterung (30); das Gestell (90) mit einer ersten Stange (92a) und mit einer zweiten Stange (92b) gebildet ist; die erste Schiene (22) einen vorderen Teil (34a) und einen hinteren Teil (34b) aufweist; die dritte Schiene (32) beweglich an der zweiten Schiene (24) befestigt und am Fahrwerk (88) montiert ist; die Halterungsbasis (26, 200) an der ersten Schiene (22) in einer Position angrenzend zum vorderen Teil (34a) der ersten Schiene (22) befestigt ist; die erste Halterung (28, 204) an der ersten Stange (92a) montiert ist; die zweite Halterung (30) beweglich an der ersten Schiene (22) in einer Position angrenzend zum hinteren Teil (34b) der ersten Schiene (22) befestigt und an der zweiten Stange (92b) montiert ist; beim Herausziehen der dritten Schiene (32) relativ zur ersten Schiene (22) die zweite Schiene (24) zum Verschieben in eine Ausfahrrichtung (D1) aus der eingezogenen Position in die ausgestreckte Position relativ zur ersten Schiene (22) angetrieben wird; beim Verschieben die zweite Schiene (24) die erste Schiene (22) antreibt, um die Halterungsbasis (26, 200) aus der ersten Position (P1) in die zweite Position (P2) relativ zur ersten Halterung (28, 204) zu verschieben.

10. Die Laufschienenmontage (20) nach Anspruch 1, weiter umfassend eine dritte Schiene (32) und eine zweite Halterung (30); das Gestell (90) mit einer ersten Stange (92a) und mit einer zweiten Stange (92b) gebildet ist; die erste Schiene (22) einen vorderen Teil (34a) und einen hinteren Teil (34b) aufweist; die dritte Schiene (32) der Länge nach verschiebbar an der zweiten Schiene (24) befestigt und am Fahrwerk (88) montiert ist; die Halterungsbasis (26, 200) an der ersten Schiene (22) in einer Position angrenzend zum vorderen Teil (34a) der ersten Schiene (22) befestigt ist; die erste Halterung (28, 204) an der ersten Stange (92a) montiert ist; die zweite Halterung (30) beweglich an der ersten Schiene (22) in einer Position angrenzend zum hinteren Teil (34b) der ersten Schiene (22) befestigt und an der zweiten Stange (92b) montiert ist; beim Antreiben mit der dritten Schiene (32) zum Verschieben in eine Ausfahrrichtung (D1) die zweite Schiene (24) die erste Schiene (22) antreibt, um die Halterungsbasis (26, 200) aus der ersten Position (P1) in die zweite Position (P2) relativ zur ersten Halterung (28, 204) zu verschieben.

11. Die Laufschienenmontage (20) nach Anspruch 9 oder 10, worin das Fahrwerk (88) mit einem ersten Teil (94) und mit einem zweiten Teil (96) gebildet ist; der erste Teil (94) eine Breite (W1) aufweist, die größer als eine Breite (W2) des zweiten Teils (96) ist; die dritte Schiene (32) an einer lateralen Seite (98) des zweiten Teils (96) des Fahrwerks (88) montiert ist.

12. Die Laufschienenmontage (20) nach Anspruch 10, worin die Halterungsbasis (26, 200) weiter eine obere Wand (44a), eine untere Wand (44b) und eine Seitenwand (46) aufweist, wobei die Seitenwand (46) zwischen der oberen Wand (44a) und der unteren Wand (44b) gebildet ist; die obere Wand (44a), die untere Wand (44b) und die Seitenwand (46) zusammen einen Kanal (48) bilden; die erste Halterung (28, 204) eine Seitenwand (58) und ein Endplättchen (60) aufweisen, wobei das Endplättchen (60) im Wesentlichen an der Seitenwand (58) befestigt ist; die Seitenwand (58) der ersten Halterung (28, 204) beweglich im Kanal (48) der Halterungsbasis (26, 200) angeordnet ist.

## Revendications

1. Ensemble de glissières (20) pour monter un châssis (88) sur un rack (90), **caractérisé par le fait qu'**il comprend :
un premier rail (22) définissant une gorge (36) ;
une base de support (26, 200) raccordée au premier rail (22) ;
un premier support (28, 204) adapté pour être fixé sur le rack et auquel la base de support (26, 200) est raccordée de manière mobile ; et
un deuxième rail (24) raccordé de manière mobile au premier rail (22) et déplaçable de manière longitudinale par rapport au premier rail (22), **caractérisé par le fait que**
le premier support (28, 204) comprend une ouverture (64) et un élément d'engagement (66), l'élément d'engagement (66) comporte un bras élastique (70) et une partie d'engagement (72) raccordée de manière transversale au bras élastique (70) et correspondant à l'ouverture (64),
**caractérisé en ce que**,
le deuxième rail (24) est capable d'entraîner le premier rail (22) tout en étant déplacé dans la gorge (36) par rapport au premier rail (22) depuis une position rétractée jusqu'à une position déployée pour déplacer la base de support (26, 200) par rapport au premier support (28, 204) depuis une première position (P1) vers une second position (P2), et
la base de support (26, 200) est raccordée de manière fixe au premier rail (22) et comprend un trou perforant (50), et
lorsque la base de support (26, 200) est à la seconde position (P2) par rapport au premier support (28, 204), la partie d'engagement (72) de l'élément d'engagement (66) s'étend à travers l'ouverture (64) du premier support (28, 204) dans le trou perforant (50) de la base de support (26, 200) du fait de la force élastique du bras élastique (70) et s'engage avec la base de support (26, 200).

2. Ensemble de glissières (20) selon la revendication 1, **caractérisé par le fait que** tout en étant déplacé dans une direction d'extension (D1) depuis la position rétractée jusqu'à la position déployée par rapport au premier rail (22), le deuxième rail (24) entraîne le premier rail (22) pour déplacer la base de support (26, 200) depuis la première position (P1) jusqu'à la seconde position (P2) par rapport au premier support (28, 204).

3. Ensemble de glissières (20) selon la revendication 1, **caractérisé par le fait que** le premier rail (22) comporte une partie avant (34a) et une partie arrière (34b), la base de support (26, 200) est raccordée au premier rail (22) à une position adjacente à la partie avant (34a) du premier rail (22), et l'ensemble de glissières (20) comprend en outre un autre support (30) raccordé de manière mobile au premier rail (22) à une position adjacente à la partie arrière (34b) du premier rail (22).

4. Ensemble de glissières (20) selon la revendication 1, **caractérisé par le fait que** le deuxième rail (24) comporte en outre un élément de désengagement (42), et alors que le deuxième rail (24) est déplacé depuis la position déployée jusqu'à la position rétractée par rapport au premier rail (22), l'élément de désengagement (42) du deuxième rail (24) pousse la partie d'engagement (72) de l'élément d'engagement (66) dans une direction de désengagement (D3) et la base de support (26, 200) désengage la partie d'engagement (72) de l'élément d'engagement (66) du trou perforant (50), afin de permettre au deuxième rail (24) d'entraîner le premier rail (22) pour déplacer la base de support (26, 200) depuis la seconde position (P2) jusqu'à la première position (P1) par rapport au premier support (28, 204).

5. Ensemble de glissières (20) selon la revendication 2, **caractérisé par le fait que** la base de support (26, 200) comprend en outre une partie de blocage (52), le premier support (28, 204) comprend en outre une partie de pression (62), et lorsque la base de support (26, 200) est à la première position (P1) par rapport au premier support (28, 204), la partie de blocage (52) de la base de support (26, 200) peut être bloquée par la partie de pression (62) du premier support (28, 204).

6. Ensemble de glissières (20) selon la revendication 1, **caractérisé par le fait que** le premier support (28, 204) comprend une paroi latérale (58) et une plaque d'extrémité (60) raccordée de manière sensiblement perpendiculaire à la paroi latérale (58), l'ensemble de glissières (20) comprend en outre au moins un élément de montage (67) et une broche (68) qui sont raccordés à la plaque d'extrémité (60), et la broche (68) incorpore un élément de raccordement mobile, basé sur l'engagement (74).

7. Ensemble de glissières (20) selon la revendication 1, **caractérisé par le fait que** la base de support (26, 200) comprend en outre une paroi supérieure (44a), une paroi inférieure (44b), et une paroi latérale (46) servant de raccordement entre la paroi supérieure (44a) et la paroi inférieure (44b) ; la paroi supérieure (44a), la paroi inférieure (44b), et la paroi latérale (46) définissent conjointement une gorge (48) ; et le premier support (28, 204) comprend une paroi latérale (58) déplaçable dans la gorge (48) de la base de support (26, 200).

8. Ensemble de glissières (20) selon la revendication 2, **caractérisé par le fait que** la base de support (200) comprend en outre un trou d'engagement (202), le premier support (204) comprend en outre une partie faisant saillie (206) correspondant au trou d'engagement (202), et lorsque la base de support (200) est à la seconde position (P2) par rapport au premier support (204), la partie faisant saillie (206) du premier support (204) pénètre dans le trou d'engagement (202) de la base de support (200).

9. Ensemble de glissières (20) selon la revendication 1, **caractérisé par le fait qu'**il comprend en outre un troisième rail (32) et un second support (30), **caractérisé par le fait que** le rack (90) comprend un premier montant (92a) et un second montant (92b) ; le premier rail (22) comporte une partie avant (34a) et une partie arrière (34b) ; le troisième rail (32) est raccordé de manière mobile au deuxième rail (24) et monté avec le châssis (88) ; la base de support (26, 200) est raccordée au premier rail (22) à une position adjacente à la partie avant (34a) du premier rail (22) ; le premier support (28, 204) est monté sur le premier montant (92a) ; le second support (30) est raccordé de manière mobile au premier rail (22) à une position adjacente à la partie arrière (34b) du premier rail (22) et monté sur le second montant (92b) ; et alors qu'il est retiré par rapport au premier rail (22), le troisième rail (32) entraîne le deuxième rail (24) en déplacement dans une direction d'extension (D1) depuis la position rétractée jusqu'à la position déployée par rapport au premier rail (22), et durant le déplacement, le deuxième rail (24) entraîne le premier rail (22) pour déplacer la base de support (26, 200) depuis la première position (P1) jusqu'à la seconde position (P2) par rapport au premier support (28, 204).

10. Ensemble de glissières (20) selon la revendication 1, **caractérisé par le fait qu'**il comprend en outre un troisième rail (32) et un second support (30), **caractérisé par le fait que** le rack (90) comprend un premier montant (92a) et un second montant (92b) ; le premier rail (22) comporte une partie avant (34a) et une partie arrière (34b) ; le troisième rail (32) est raccordé de manière longitudinale et mobile au deuxième rail (24) et monté avec le châssis (88) ; la base de support (26, 200) est raccordée au premier rail (22) à une position adjacente à la partie avant (34a) du premier rail (22) ; le premier support (28, 204) est monté sur le premier montant (92a) ; le second support (30) est raccordé de manière mobile au premier rail (22) à une position adjacente à la partie arrière (34b) du premier rail (22) et monté sur le second montant (92b) ; et lorsque entraîné par le troisième rail (32) en déplacement dans une direction d'extension (D1), le deuxième rail (24) entraîne le premier rail (22) pour déplacer la base de support (26, 200) depuis la première position (P1) jusqu'à la seconde position (P2) par rapport au premier support (28, 204).

11. Ensemble de glissières (20) selon la revendication 9 ou 10, **caractérisé par le fait que** le châssis (88) comprend une première partie (94) et une seconde partie (96), la première partie (94) a une largeur (W1) supérieure à une largeur (W2) de la seconde partie (96), et le troisième rail (32) est monté sur un côté latéral (98) de la seconde partie (96) du châssis (88).

12. Ensemble de glissières (20) selon la revendication 10, **caractérisé par le fait que** la base de support (26, 200) comprend en outre une paroi supérieure (44a), une paroi inférieure (44b), et une paroi latérale (46) servant de raccordement entre la paroi supérieure (44a) et la paroi inférieure (44b) ; la paroi supérieure (44a), la paroi inférieure (44b), et la paroi latérale (46) définissent conjointement une gorge (48) ; le premier support (28, 204) comprend une paroi latérale (58) et une plaque d'extrémité (60) raccordée de manière sensiblement perpendiculaire à la paroi latérale (58) ; et la paroi latérale (58) du premier support (28, 204) est déplaçable dans la gorge (48) de la base de support (26, 200).
